# EUROPÄISCHE PATENTSCHRIFT

(11) **EP 3 565 121 B1**
(45) Veröffentlichungstag und Bekanntmachung des Hinweises auf die Patenterteilung: **22.01.2025**
(21) Anmeldenummer: 19176811.8
(22) Anmeldetag: 07.03.2018
(51) Int. Cl.: H03K 17/96, H04L 12/413

(54) **BERÜHRUNGSSENSITIVES BEDIENELEMENT**
TOUCH SENSITIVE OPERATING ELEMENT
ÉLÉMENT DE COMMANDE TACTILE

(30) Priorität: 08.03.2017 AT 500382017
(43) Veröffentlichungstag der Anmeldung: 06.11.2019
(62) Teilanmeldung aus: 18160539.5
(73) Patentinhaber: Loxone Electronics GmbH, 4154 Kollerschlag (AT)
(72) Erfinder: Moser, Thomas, 4154 Kollerschlag (AT)
(74) Vertreter: Burgstaller, Peter

(56) Entgegenhaltungen:
- EP-A2- 2 624 453
- DE-A1- 102007 016 075
- DE-A1- 102008 052 816
- DE-U1- 202015 007 999
- E-MASTERS GMBH & CO. KG: "So funktioniert Smart Home: intelligent modernisieren mit e-masters", 6 June 2017 (2017-06-06), INTERNET, pages 1 - 2, XP093213077, Retrieved from the Internet <URL:https://web.archive.org/web/20170606070355/https://www.intelligent-modernisieren.de/ratgeber/themen-von-a-bis-z/so-funktioniert-smart-home.html>

## Beschreibung

Die Erfindung betrifft ein berührungssensitives Bedienelement zur Steuerung einer Smart Home Anwendung und/oder von Geräten von Gebäudeautomationssystemen, wobei das Bedienelement hinter einer undurchsichtigen Oberfläche angebracht ist und durch Berührung der Oberfläche durch am Bedienelement angebrachten Berührungssensoren gesteuert wird.

Unter einem Smart Home versteht man technische Verfahren und Systeme in Wohnräumen, welche eine Steigerung der Lebensqualität und Sicherheit als Ziel haben und verschiedenste technische Haushalts- und Wohnraumgeräte durch Datenverarbeitungsanlagen (z.B. Bussystem) vernetzen. Beispielsweise können Smart Home Elemente wie Leuchten, Jalousien, Heizung, Haushaltsgeräte, etc. durch ein zentrales Steuerungssystem bedient werden. Dadurch kann die gesamte Haustechnik automatisiert gesteuert werden.

Unter einem Smart Home Bedienelement versteht man eine Vorrichtung zur Steuerung von Smart Home Elementen (z.B. Haushalts und Wohnraumgeräte), welche durch eine Datenverarbeitungsanlage vernetzt sind.

Nach dem Stand der Technik sind Smart Home Bedienelemente bekannt, welche stationär als Schalter an Wänden angebracht oder als mobile Geräte (beispielsweise in Form einer App am Smartphone oder Tablet) ausgeführt werden können. Die stationären Schalter werden beispielsweise durch Unterputzdosen in Wände integriert und können als berührungssensitive Schalter ausgeführt werden. Die stationären oder mobilen Bedienelemente können mit dem Haussteuerungssystem beliebig vernetzt werden, wodurch eine manuelle Steuerung ermöglicht wird. Nachteilig an den bisherigen Bedienelementen ist, dass diese immer sichtbar im Wohnbereich sind, wodurch diese auch bei besonders exponierten Stellen oder beispielsweise durch einfaches Fallenlassen bruchgefährdet sind. Zusätzlich können die Bedienelemente im Wohnraum auch optisch als störend empfunden werden.

Weiters ist ein System bekannt, bei welchem in einer Küchenarbeitsplatte ein Bildschirm als Eingabefläche (z.B. vollwertiges mobiles oder eingebautes Tablet) integriert ist. Dadurch können alle Funktionen, die beispielsweise von einem mobilen Tablet mit integrierter mobiler Smart Home App ausgeführt werden können, direkt durch Eingabe über die Küchenarbeitsplatte gesteuert werden (z.B. Steuerung von Küchengeräten, Abspielen von Musik oder Abrufen von Internetseiten). Nachteilig an diesen Systemen ist, dass die Herstellung der Küchenarbeitsplatte sehr kostenintensiv ist, da beispielsweise für eine flächige Berührungsdetektion eine hohe Sensordichte erforderlich ist und ein Nachrüsten bei bereits bestehenden Küchen nur durch Austausch der gesamten Arbeitsplatte möglich ist. Zur Bedienung der Arbeitsplatte beinhaltet diese verschiedene Glaselemente, welche bruchgefährdet und dadurch wartungsintensiv sind. Zusätzlich ist die Bedienbarkeit von Bildschirmen als Eingabefläche stark eingeschränkt, wenn diese mit feuchten Händen bedient werden. Da insbesondere im Küchenbereich sehr oft mit feuchten Händen gearbeitet wird, ist somit die Steuerung der Smart Home Bedienelemente in diesem Wohnbereich ebenfalls eingeschränkt.

Aus der DE 20 2015 007 999 U1 ist ein Plattenkörper bekannt, umfassend eine gedruckte Schaltung aufweisende Funktionsschicht, welche auf eine Trägerplatte gedruckten ist und zwischen der Trägerplatte und der Deckschicht des Plattenkörpers vorliegt. Nachteilig ist, dass dieser Plattenkörper nur als Ersatz einer bestehenden Platten nachrüstbar ist und nur in dem in der DE 20 2015 007 999 U1 beschriebenen System einsetzbar ist. Nachteilig ist, dass die Funktionsschicht fest eingeschlossen im Schichtaufbau der Platte vorliegt. Der Platenkörper kann ein Bedienelement umfassen, wobei eine Sperrung des Bedienelements für die Eingabe nicht beschrieben ist.

Die EP2624453A2 offenbart eine Vorrichtung zur Betätigung eines in oder an einem Körper angeordneten elektrischen Verbrauchers, insbesondere für eine Antriebsvorrichtung für eine Schließ- oder Öffnungsbewegung des Körpers. Die Vorrichtung der EP2624453A2 kann als ein kapazitiver Geräteschalter angesehen werden, welcher auf das Gerät selbst bzw. dessen Verbraucher wirkt. In der EP2624453A2 ist beschrieben, dass das Risiko einer Fehlbedienung einer Antriebseinrichtung gesenkt werden kann, wenn die Eingabe eines Eingabemusters oder einer Geste erkannt wird. Die Vorrichtung zur Eingabe ist dabei immer aktiv, bzw. ist eine Sperrung des Bedienelements selbst nicht beschrieben.

In der US2013100033A1 wird ein kapazitiv-gesteuertes Touchpanel für Küchen- oder Badezimmeranwendungen beschrieben, welches für die Benutzung in feuchten Umgebungen konzipiert ist und die Fehlerhäufigkeit während der Bedienung bei Vorkommen von Wassertropfen minimiert. Das in der US2013100033A1 beschriebene Touchpanel ist primär darauf ausgelegt direkt an die jeweilige Küchen- oder Badezimmeranwendung angebracht zu werden und nicht zur Steuerung von Smart Home Anwendungen ausgelegt. Zusätzlich muss bei den beschriebenen Touchpanels ebenfalls die Oberfläche des Touchpanels frei liegen und zur Steuerung berührt werden, womit die Oberfläche des Touchpanels bruchgefährdet ist.

Die DE 10 2005 027 572 B3 betrifft ein Bedienelement eines Geschirrspülers. Kapazitive Näherungssensoren befinden sich hinter einer Glasoberfläche, welche bei Annäherung eines Objekts durchsichtig wird. Das Bedienelement der DE 10 2005 027 572 B3 ist somit ein Touchpanel mit Glasfläche, wobei die Anzeigeelemente des Touchpanels bei Bedienung sichtbar werden. Beim Bedienelement muss ebenfalls die Oberfläche des Touchpanels frei liegen und zur Steuerung berührt werden, womit die Oberfläche des Touchpanels bruchgefährdet ist. Das Bedienelement steuert das Gerät, an welchem es angebracht ist, wobei das Bedienelement im Gerät verbaut ist, sodass Gerät und Bedienelement eine Einheit bilden.

Die EP1881649A2 zeigt die Steuerung eines Gebäudesystems mit einem Touchscreen. Da der Touchscreen außen an einer Oberfläche anzubringen ist, ist dieser bruchgefährdet und Umwelteinflüssen voll ausgesetzt.

Die WO 2007124754 A2 zeigt ein elektrisch verstellbares Möbelstück, welches zumindest einen durch einen Motor angetriebenen Aktuator und/oder eine Hubsäule aufweist. Zur Bedienung des Möbelstücks weist dieses Berührungstasten auf, welche hinter einer Oberfläche des Möbelstücks vorliegen können, wobei auf der Oberfläche des Möbels entsprechende Markierungen vorgesehen sein können. Nachteilig ist, dass eine unbeabsichtigte Berührung der Berührungstasten eine ungewollte Verstellung des Möbelstücks herruft. Während der Benutzer bei dieser Anwendung ein Feedback durch die Bewegung des Möbelstücks erhält, würde bei anderen Anwendungen, bei welchen der Benutzer kein direktes Feedback erhält, eine ungewollte Betätigung möglicherweise unerkannt bleiben, beispielsweise eine Änderung der Raumtemperatur oder das Öffnen von Türen und Fenstern.

Aufgabe der Erfindung ist es robustere Bedienelemente für die Steuerung von Smart Home Anwendungen bereit zu stellen bzw. Bedienelemente von Smart Home Anwendungen besser vor Umgebungseinflüssen zu schützen, wobei eine unbeabsichtigte oder unbemerkte Aktivierung des Bedienelements verhindert werden soll.

Zur Lösung der Aufgabe wird die Verwendung eines berührungssensitives Bedienelement gemäß Anspruch 1 vorgesehen.

Gemäß Anspruch 1 wird zur Lösung der Aufgaben ein berührungssensitives Bedienelement zur Steuerung einer Smart Home Anwendung und/oder von Geräten von Gebäudeautomationssystemen vorgeschlagen, welches hinter einer permanent undurchsichtigen Oberfläche einer Gebäudewand, eines Möbels, einer Küche oder einer Arbeitsplatte angebracht ist und kapazitive Berührungssensoren aufweist, welche Berührungen von Benutzern der permanent undurchsichtigen Oberfläche durch diese hindurch detektieren, wobei jeder Berührungssensor die Berührung der undurchsichtigen Oberfläche in einem Bereich wahrnimmt, sodass an der den Berührungssensoren gegenüberliegenden Fläche der undurchsichtigen Oberfläche mehrere Berührungspunkte beziehungsweise Berührungsbereiche definiert sind, wobei mehrere Berührungssensoren zur Steuerung der Smart Home Anwendung und/oder der Geräte von Gebäudeautomationssystemen dienen wobei das Bedienelement mit einer zentralen Datenverarbeitungsanlage eines Gebäudes kommuniziert, welche auf Basis der detektierten Berührungen und dazu hinterlegten Steuerungsvorschriften dezentrale Geräte des Gebäudeautomationssystems steuert oder regelt, wobei eine ungewollte und/oder unbemerkte Aktivierung des berührungssensitiven Bedienelements verhindert wird, durch eine oder mehrere der Maßnahmen ausgewählt aus der Gruppe von Maßnahmen umfassend:
Aktivieren des Bedienelements ausgehend von einem gesperrten Zustand durch Berührung eines oder mehrerer Berührungssensoren;
Ausgabe eines akustischen oder fühlbaren Signals durch das Bedienelement, als Rückmeldung zum Status des Bedienelements an den Benutzer;
Ausgabe eines optischen Signals durch das Bedienelement, als Rückmeldung zum Status des Bedienelements an den Benutzer, wobei das Bedienelement ein oder mehrere Leuchtmittel aufweist, wobei die Leuchtmittel hinter Öffnungen oder in Öffnungen der undurchsichtigen Oberfläche vorliegen.

Bei der permanent undurchsichtigen Oberfläche handelt es sich z.B. um eine undurchsichtige, elektrisch nicht-leitende Oberfläche einer Küchenarbeitsplatte, eines Möbels, einer Fliese oder eines Tisches.

Dadurch wird erreicht, dass die Bruchgefahr des Bedienelements minimiert ist, sowie die Bedienung auch in feuchten Umgebungen ermöglicht wird. Zudem wird weder auf der Oberfläche, noch in einer nach außen hin offenen Ausnehmung der Oberfläche ein Bedienelement angebracht, sodass die Integrität der Oberfläche gewahrt bleibt, also geschlossen bleibt und keine Vorsprünge aufweist.

Bevorzugt weist das berührungssensitive Bedienelement einen flächigen Aufbau mit mehreren zueinander beabstandeten Berührungssensoren auf, wobei jeder Berührungssensor die Berührung der undurchsichtigen Oberfläche in einem diskreten Bereich wahrnimmt, sodass an der den Berührungssensoren gegenüberliegenden Fläche der undurchsichtigen Oberfläche mehrere diskrete Berührungspunkte beziehungsweise Berührungsbereiche definiert sind. Dadurch wird erreicht, dass mit wenigen Sensoren das Auslangen gefunden wird, was insbesondere gegenüber Bedienelementen mit Touchscreen besonders kostengünstig ist.

Die kapazitiven Berührungssensoren arbeiten bevorzugt nach dem nach Stand der Technik bekannten "Self Capacitance Charge Transfer" Prinzips. Bei diesem bildet das Bedienelement nach Erde einen Kondensator, welcher stetig geladen und entladen wird. Beim Entladen wird die Dauer gemessen, bis ein gewisser Spannungswert unterschritten ist. Wird die Oberfläche an einer Stelle mit darunterliegendem kapazitiv-gesteuertem Berührungssensor von einem Menschen berührt, erfolgt eine Veränderung der Gesamtkapazität des Berührungssensors. Der Kondensator benötigt dadurch länger zum Entladen, was durch eine Software als Berühren des Berührungssensors des Bedienelements ausgewertet werden kann.

Bevorzugt weist die undurchsichtige Oberfläche an der dem Benutzer zugewandten Seite sichtbare und/oder fühlbare Markierungen auf, welche entsprechend den diskreten Berührungspunkten beziehungsweise Berührungssensoren angeordnet sind. Dadurch wird dem Benutzer angezeigt, welchen Berührungssensor bzw. welche zu diesem hinterlegte Funktion er an welcher Position, also welchen Berührungspunkt, der Oberfläche steuern kann. Die fühlbare Markierung kann bevorzugt als eine feine erhabene Struktur vorliegen oder als eine Gravur vorliegen, welche das die Oberfläche aufweisende Element jedenfalls nicht vollständig durchdringt.

Bevorzugt kann das Bedienelement ausgehend von einem gesperrten Zustand durch Berührung eines oder mehrerer Berührungssensoren aktiviert werden. So wird eine unbeabsichtigte Aktivierung von Funktionen der Smart Home Anwendung vermieden, was insbesondere vorteilhaft ist, wenn auf der Oberfläche gearbeitet wird, was beispielsweise der Fall ist, wenn die Oberfläche einer Arbeitsplatte zugehört.

Bevorzugt wird dem Benutzer durch ein Signal mitgeteilt, wenn das Bedienelement aktiviert ist. Bevorzugt können ein oder mehrere Leuchtmittel den aktiven Modus anzeigen, wobei die Leuchtmittel hinter oder in Öffnungen der Oberfläche vorliegen, wobei die Öffnungen bevorzugt mit transparentem oder zumindest durchscheinendem Material dichtend verschlossen sind. Die Leuchtmittel können zur Anzeige des aktivierten Zustands einem Countdown gleichend nacheinander aufleuchten und/oder erlöschen, wodurch vorteilhaft dem Benutzer die Zeit angezeigt wird, welche ihm zur Bedienung des Bedienelements verbleibt.

Alternativ kann bei Berührung zumindest eines der Berührungssensoren ein akustisches Signal wiedergegeben werden. Vorteilhaft daran ist, dass die Oberfläche keine Öffnungen aufzuweisen braucht und der aktivierte Zustand somit durch die Oberfläche hindurch an den Benutzer kommuniziert werden kann.

Der Abstand der Berührungssensoren zur gegenüberliegenden Fläche der undurchsichtigen Oberfläche beträgt bevorzugt zwischen 1 mm und 30 mm, da in diesem Bereich die Detektion durch die kapazitiven Berührungssensoren besonders zuverlässig erfolgen kann.

Bevorzugt ist die undurchsichtige Oberfläche, hinter welcher das berührungssensitive Bedienelement angebracht ist, kein Teil der mit dem berührungssensitiven Bedienelement gesteuerten Vorrichtungen. Dies bedeutet, dass durch das berührungssensitive Bedienelement bevorzugt Geräte und Funktionen gesteuert werden, welche unabhängig und entfernt von der Oberfläche sind, auf welchen es angebracht ist. Vorteilhaft daran ist, dass das Bedienelement nicht wie üblich im Gerät selbst verbaut ist, wie beispielsweise Taster von Ceranfeldern. Bei im Gerät verbauten Bedienelementen ist nachteilig, dass diese bei Beschädigung des Geräts mit diesem auszutauschen sind, bzw. das gesamte Gerät bei Beschädigung des Bedienelements zu tauschen ist. Vorteilhaft an der gegenständlichen Erfindung ist somit, dass die bedienten Geräte und deren Bedienelemente unabhängig voneinander sind und somit beliebig austauschbar und ergänzbar sind. Durch Anbringung des Bedienelements hinter der Oberfläche kann dieses jederzeit entfernt werden, ohne eine optische oder funktionelle Beeinträchtigung (z.B. offene Hohlräume oder Schraubenlöcher) auf der Oberfläche zu hinterlassen.

Bevorzugt kommuniziert das Bedienelement, besonders bevorzugt drahtlos (z.B. W-LAN), mit einer zentralen Datenverarbeitungsanlage eines Gebäudes, welche auf Basis der detektierten Berührungen und dazu hinterlegten Steuerungsvorschriften dezentrale Geräte des Gebäudeautomationssystems steuert oder regelt. Vorteilhaft kann dadurch erreicht werden, dass das Bedienelement besonders flexibel einsetzbar ist, da die in der Datenverarbeitungsanlage hinterlegten Steuerungsvorschriften für die Berührungssensoren beliebig festlegbar und änderbar sind, sodass bei einem Gerätetausch oder beim Anbringen eines erfindungsgemäßen Bedienelements nur diese Steuerungsvorschriften geändert werden müssen und keine Verkabelung oder direkte Kommunikation des Bedienelements mit dezentrale Geräte des Gebäudeautomationssystems nötig ist.

Durch Anbringung unter der Oberfläche wird somit ein Bruch- und Stoßschutz für das Bedienelement erreicht, wobei die Integrität der Oberfläche bei Anbringung des Bedienelements nicht beeinträchtigt wird. Durch die auf der Oberfläche bevorzugt vorgesehene Markierung bzw. Gravur wird dennoch eine gezielte Bedienung des unter der Oberfläche angebrachten Bedienelements ermöglicht, wobei durch die bevorzugt vorgesehene Ausgabe eines optischen, akustischen oder fühlbaren Signals durch das Bedienelement, eine Rückmeldung zum Status des Bedienelements an den Benutzer gegeben werden kann.

Die Erfindung wird an Hand von Zeichnungen veranschaulicht:
- Fig. 1:: zeigt die zur Unterseite der Oberfläche hingewandte flächige Seite einer beispielhaften Ausführung des erfindungsgemäßen Bedienelements.
- Fig. 2:: zeigt eine schematische beispielhafte Ausführung einer Gravur auf einer Oberfläche.
- Fig. 3:: zeigt eine beispielhafte Schnittzeichnung des erfindungsgemäßen Bedienelements hinter einer Platte.

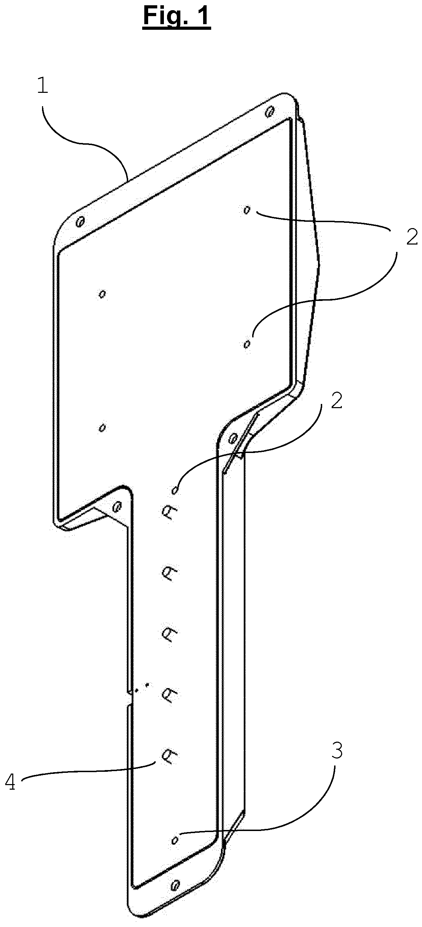

In Fig. 1 wird die zur Oberfläche hingewandte flächige Seite einer beispielhaften Ausführung des erfindungsgemäßen Bedienelements 1 dargestellt. Das Bedienelement 1 ist mit Berührungssensoren 2, 3 versehen, welche im Falle einer Berührung der Oberfläche ein Signal an eine Datenverarbeitungsanlage bzw. ein Smart Home System weitergeben. In einer Ausführungsvariante wird zusätzlich bei Detektion einer Berührung durch Berührungssensoren 2, 3 ein akustisches Signal der Oberfläche ausgelöst, wodurch der Benutzer ein Feedback erhält. In der gezeigten beispielhaften Ausführung ist das Bedienelement 1 mit sechs Berührungssensoren 2, 3 und fünf Leuchtmitteln 4 ausgestattet. Sollten keine Leuchtmittel 4 und kein Berührungssensor 3 vorgesehen sein, kann auf den länglichen schmalen Fortsatz, der die Leuchtmittel trägt, verzichtet werden, sodass das Bedienelement 1 lediglich den in der Fig. 1 oberen rechteckigen bzw. bevorzugt quadratischen Teil aufweist. Bei dieser Ausführungsvariante können lediglich die vier im Eckbereich des Rechtecks angeordneten Berührungssensoren 2 vorgesehen sein, oder bevorzugt ein fünfter Berührungssensoren 2 zentral zwischen diesen vier Berührungssensoren 2 vorgesehen sein. Ein zentraler Berührungssensor 2 im Mittelpunkt des quadratischen Flächenbereichs des Bedienelements 1 kann natürlich auch bei der in den Figuren dargestellten Ausführungsvariante vorteilhaft ergänzt werden.

Die Art der Leuchtmittel 4 kann beliebig gewählt sein, besonders bevorzugt sind diese aber Leuchtdioden (LED). Die Leuchtmittel 4 ragen in Öffnungen 6 in der Oberfläche, wobei diese Öffnungen dichtend beispielsweise mit teilweise transparentem bzw. durchscheinendem Material (z.B. durchsichtiges Harz) ausgegossen werden können, damit die Oberfläche und die darunterliegenden LED wasser- und schmutzresistent geschützt sind. Die Anzahl und die örtliche Anbringung der Berührungssensoren 2, 3 und Leuchtmittel 4 am Bedienelement 1 kann beliebig variiert werden.

In einer besonders bevorzugten Variante wird das Bedienelement 1 durch Berühren der Oberfläche oberhalb des Berührungssensors 3 aktiviert bzw. für die Eingabe entsperrt. Nach der Aktivierung können die Leuchtmittel 4 beliebig aufleuchten, beispielsweise ähnlich einem Countdown der Reihe nach, beginnend mit dem zum Berührungssensor 3 nähesten Leuchtmittel 4. Eine weitere Möglichkeit wäre ein gleichzeitiges Aufleuchten aller Leuchtmittel 4, oder ein gleichzeitiges mehrmaliges Blinken aller Leuchtmittel 4 während dem Zeitraum des aktiven Modus. Während ein oder mehrere Leuchtmittel 4 leuchten oder blinken, kann durch Berührung der Oberfläche das darunterliegende Bedienelement 1 bzw. deren Berührungssensoren 2, 3 bedient werden. Sobald die Leuchtmittel 4 nicht mehr leuchten, sind die Berührungssensoren 2 deaktiviert und das Bedienelement 1 ist für Eingaben gesperrt. Sobald das Bedienelement 1 im deaktivierten Modus ist, kann die Oberfläche (z.B. Küchenarbeitsplatte) ganz normal benutzt werden, beispielsweise zum Schneiden, Wischen oder als Ablagefläche, ohne dass es zu einer unbeabsichtigten Bedienung des Bedienelements 1 kommt. Durch die Aktivierung bzw. Deaktivierung kann somit ein gezielter Einsatz des integrierten Bedienelements 1 gesichert werden, wodurch kein Verlust an Arbeitsfläche sowie eine bruchsichere Umgebung für das Bedienelement 1 gewährleistet wird. In einer anderen Ausführungsvariante kann das Bedienelement 1 so ausgeführt sein, dass dieses nicht durch Berühren des Berührungssensors 3 aktiviert werden muss, sondern sich immer im aktivierten Modus befindet und daher immer für Eingaben entsperrt ist. Diese Ausführungsvariante ist beispielsweise bei Oberflächen, welche nicht ständig berührt oder zum Arbeiten verwendet werden möglich (z.B. Einbau in einem Wandschrank).

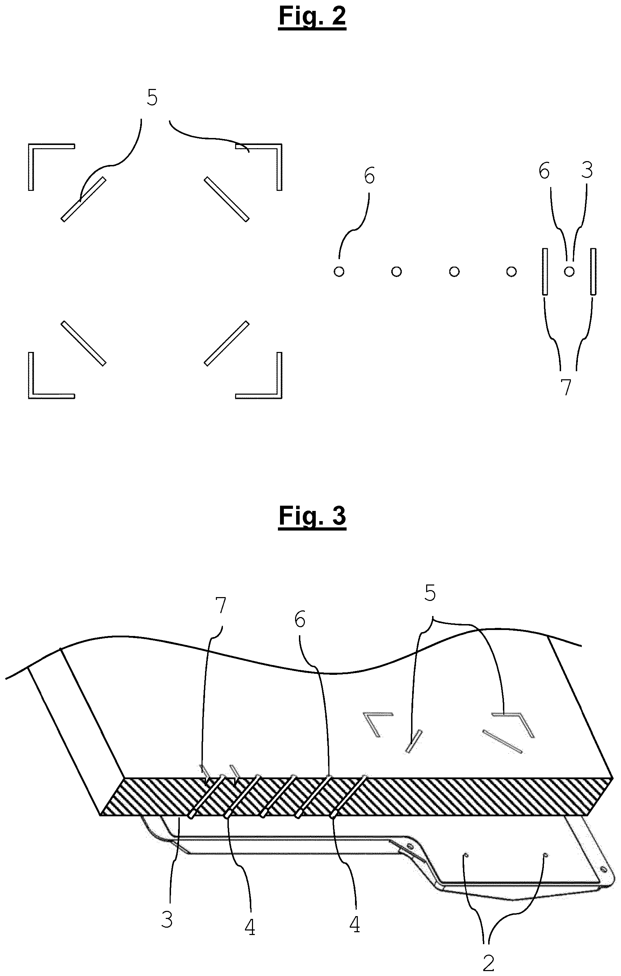

In der Fig. 2 wird eine schematische beispielhafte Ausführung einer Gravur 5 in einer beliebigen nicht-leitenden Oberfläche dargestellt. Unter den Elementen der Gravur 5 befinden sich die Berührungssensoren 2 (nicht in Figur dargestellt). Beispielsweise sind vier Berührungssensoren 2 unter den schrägen Elementen der Gravur 5 angebracht. Die Öffnungen 6 nehmen die Leuchtmittel 4 auf, wobei die fünfte Öffnung 6 von einer Gravur 7 umgeben ist, die einen Berührungssensor 3 (nicht in Figur dargestellt) kennzeichnet, dessen Detektionsbereich mit dem untersten Leuchtmittel 4 überlappt. Durch Berühren der fünften Öffnung 6 zwischen der Gravur 7 wird das Bedienelement 1 aktiviert.

Bevorzugt ist das Bedienelement hinter einer permanent undurchsichtigen Arbeitsplatte angebracht, wobei die Steuerung der Smart Home Anwendung und/oder von Geräten von Gebäudeautomationssystemen durch das berührungssensitives Bedienelement 1 im Normalzustand deaktiviert ist und erst bei Ausüben einer gezielten Benutzerhandlung, welche sich eindeutig vom normalen Gebrauch der Arbeitsplatte unterscheidet, aktiviert wird. Beispielsweise kann dies wie beschrieben durch gezielte Berührung eines Berührungssensors 3 erfolgen. Das Entsperren kann auch erfolgen, indem Berührungssensoren 2, 3 in einer bestimmten Kombination und/oder Abfolge berührt werden. Bevorzugt kann die Kombination und/oder Abfolge vom Benutzer programmiert bzw. vorgegeben werden. Dadurch kann das Entsperren nur durch Benutzer vorgenommen werden, welche die Kombination und/oder Abfolge der den Berührungssensoren 2, 3 gegenüberliegenden zu berührenden Oberflächenbereichen kennen. Beispielsweise kann als Kombination zum Entsperren vorgesehen sein, dass exakt zwei diagonal gegenüberliegende Berührungssensoren 2 zeitgleich eine Berührung detektieren müssen. Beispielsweise kann als Abfolge zum Entsperren vorgesehen sein, dass die vier Berührungssensoren 2 im Uhrzeigersinn aufeinanderfolgend eine Berührung detektieren müssen.

In der Fig. 3 wird ein beispielhafter Einbau eines Bedienelements 1 hinter einer Platte dargestellt. Die Oberfläche der Platte weist eine beispielhafte Gravur 5, 7 auf. An der Unterseite der Platte ist das Bedienelement 1 angebracht. Unter jedem durch die Gravur 5 gekennzeichneten Berührungspunkt befindet sich jeweils ein Berührungssensor 2, wobei die Berührungssensoren 2 von außen nur durch die Gravur 5 sichtbar gemacht werden. Die Öffnungen 6, welche die Platte vollständig durchdringen, beinhalten die Leuchtmittel 4, wobei nahe am fünften und letzte Leuchtmittel 4 ein Berührungssensor 3 vorgesehen ist, wodurch das Bedienelement 1 durch Berühren der letzten Öffnung 6 zwischen der Gravur 7 durch ein Signal des Berührungssensors 3 aktiviert werden kann. Die Öffnungen 6 sind bevorzugt mit zumindest teilweise transparentem bzw. durchscheinendem Material dichtend vergossen und dadurch geschlossen.

Das Bedienelement 1 kann vorteilhaft durch verschieden dicke Oberflächen hindurch bedient werden. Die Oberflächendicke liegt besonders bevorzugt in einem Bereich von 1 mm bis 30 mm. Das Bedienelement 1 kann in diesem Dickebereich vorteilhaft ohne Änderung der Sensoren bedient werden. Dies wird durch Veränderung der Empfindlichkeit der Berührungserkennung ermöglicht. Es wird mittels einer Steuerungsvorschrift für das Bedienelement 1 ein Grenz- bzw. Schwellwert gesetzt, ab welchem Kapazitätsänderungen als Berührungen registriert werden. Dadurch kann beispielsweise bei dicken Oberflächen (z.B. 30 mm) bereits bei einer geringen Kapazitätsänderung eine Berührung registriert werden, als im Vergleich zu einer dünnen Oberfläche (z.B. 1 mm), bei welcher erst bei größeren Kapazitätsänderungen eine Berührung registriert wird. Dadurch lässt sich das Bedienelement 1 ohne Änderung der Hardware individuell auf die verwendete Oberfläche und deren Dicke einstellen, womit sich die Bedienung ident für dünnere und dicke Oberflächen gestaltet. Dies wird dadurch ermöglicht, dass die kapazitiven Berührungssensoren 2 eigentlich Näherungssensoren sind, welche die Annäherung von Gegenständen ab einer gewissen Distanz, im Wesentlichen unabhängig von der Dicke der Oberfläche, erkennen können. Um aus der Detektion der Annäherung eines Gegenstandes eine Berührungsdetektion zu ermöglichen, kann der Schwellwert so gesetzt werden, dass die Distanz, ab welcher die Annäherung von Gegenständen als Berührung erfasst wird, gleich oder geringfügig größer als die Dicke der Oberfläche gesetzt wird. Natürlich könnte der Schwellwert auch so gesetzt werden, dass die Distanz, ab welcher die Annäherung von Gegenständen als Berührung erfasst wird, deutlich größer, beispielsweise um 1 mm bis 30 mm, als die Dicke der Oberfläche ist, um eine berührungslose Bedienung, also eine Bedienung ohne tatsächliche Berührung der Oberfläche zu ermöglichen. Dem Annähern und dem tatsächlichen Berühren kann vorteilhaft auch eine andere Bedeutung durch die Datenverarbeitungsanlage zugeordnet werden, bzw. unterschiedliche Steuerungsvorschriften ausgelöst werden.

Das Bedienelement 1 kann entweder die Messsignale der Berührungssensoren 2, 3 an die Datenverarbeitungsanlage senden oder lediglich bei Erreichen des Schwellwerts ein Signal, welches aussagt, dass eine Annäherung oder Berührung vorliegt, gemäß der Funktion eines Tasters. Die Kommunikation mit der Datenverarbeitungsanlage erfolgt entweder drahtgebunden, oder drahtlos. Die Datenleitungen können gleichzeitig zur Stromversorgung des Bedienelements 1 dienen.

Die Datenverarbeitungsanlage übernimmt bevorzugt die Steuerung von anderen Geräten aufgrund der Signale des Bedienelements 1. Bevorzugt ist die Datenverarbeitungsanlage der Server bzw. die zentrale Recheneinheit eines Gebäudeautomationssystems bzw. eines Smart Homes. Die Kommunikation des Bedienelements 1 erflogt dazu bevorzugt ausschließlich mit der Datenverarbeitungsanlage, welche die Steuerung von dezentralen Geräten von Gebäudeautomationssystemen vornimmt.

Zu den Signalen des Bedienelements 1 bzw. der Berührungssensoren 2, 3 können so in der Datenverarbeitungsanlage softwaretechnisch individuelle Funktionen zur Steuerung von Geräten des Smart Home Systemen hinterlegt werden. Beispielsweise können zwei Berührungssensoren 2 zur Steuerung der Wohnraumlüftung (z.B. Ein/Aus), und zwei Berührungssensoren 2 zur Steuerung einer Musikanlage (z.B. Lauter/Leiser) programmiert werden.

## Patentansprüche

1. Verwendung eines berührungssensitiven Bedienelements (1) in einem System zur Steuerung einer Smart Home Anwendung und/oder von Geräten von Gebäudeautomationssystemen umfassend zumindest ein berührungssensitives Bedienelement (1), eine zentrale Datenverarbeitungsanlage und dezentrale Geräte des Gebäudeautomationssystems, welche von der Datenverarbeitungsanlage gesteuert oder geregelt werden, wobei das Bedienelement (1) hinter einer permanent undurchsichtigen Oberfläche an der Unterseite einer Platte einer Gebäudewand, eines Möbels, einer Küche oder einer Arbeitsplatte angebracht ist und kapazitive Berührungssensoren (2, 3) aufweist, welche Berührungen von Benutzern der permanent undurchsichtigen Oberfläche durch die Platte hindurch detektieren, wobei jeder Berührungssensor (2, 3) die Berührung der undurchsichtigen Oberfläche in einem Bereich wahrnimmt, sodass an der den Berührungssensoren (2, 3) gegenüberliegenden Fläche der undurchsichtigen Oberfläche mehrere Berührungspunkte beziehungsweise Berührungsbereiche definiert sind, wobei das Bedienelement (1) mit der zentralen Datenverarbeitungsanlage kommuniziert, welche auf Basis der detektierten Berührungen und dazu hinterlegten Steuerungsvorschriften zumindest ein dezentrales Gerät des Gebäudeautomationssystems steuert oder regelt, wobei eine ungewollte und/oder unbemerkte Aktivierung des berührungssensitiven Bedienelements (1) verhindert wird,
indem die Steuerung der Smart Home Anwendung und/oder von Geräten von Gebäudeautomationssystemen durch das berührungssensitive Bedienelement (1) im Normalzustand deaktiviert ist und die Maßnahmen:
Aktivieren des Bedienelements (1) ausgehend von einem gesperrten Zustand durch Berührung eines oder mehrerer der Berührungspunkte beziehungsweise Berührungsbereiche der Berührungssensoren (2, 3) in einen aktivierten Zustand und eine oder mehrere der Maßnahmen ausgewählt aus der Gruppe von Maßnahmen umfassend:
Ausgabe eines akustischen oder fühlbaren Signals durch das Bedienelement (1), als Rückmeldung zum aktiven Status des Bedienelements (1) an den Benutzer;
oder
Ausgabe eines optischen Signals durch das Bedienelement (1), als Rückmeldung zum aktiven Status des Bedienelements (1) an den Benutzer, wobei das Bedienelement (1) ein oder mehrere Leuchtmittel (4) aufweist, wobei die Leuchtmittel (4) hinter Öffnungen (6) oder in Öffnungen (6) der undurchsichtigen Oberfläche vorliegen.

2. Verwendung nach Anspruch 1, **dadurch gekennzeichnet, dass** mehrere Berührungssensoren (2, 3) beabstandet zueinander am Bedienelement (1) vorliegen, wobei jeder Berührungssensor (2, 3) die Berührung der undurchsichtigen Oberfläche in einem diskreten Bereich wahrnimmt, sodass an der den Berührungssensoren (2, 3) gegenüberliegenden Fläche der undurchsichtigen Oberfläche mehrere diskrete Berührungspunkte beziehungsweise Berührungsbereiche definiert sind.

3. Verwendung nach einem der Ansprüche 1 oder 2, **dadurch gekennzeichnet, dass** das Bedienelement (1) mehrere Berührungssensoren (2) zur Steuerung der Smart Home Anwendung und/oder der Geräte von Gebäudeautomationssystemen aufweist und zumindest einen Berührungssensor (3) zum Entsperren der Berührungssensoren (2) zur Steuerung der Smart Home Anwendung und/oder der Geräte von Gebäudeautomationssystemen.

4. Verwendung nach einem der Ansprüche 1 bis 3, **dadurch gekennzeichnet, dass** das Bedienelement (1) ein oder mehrere Leuchtmittel aufweist, wobei die Leuchtmittel (4) hinter Öffnungen (6) oder in Öffnungen (6) der undurchsichtigen Oberfläche vorliegen, wobei die Öffnungen (6) mit transparentem oder zumindest durchscheinendem Material verschlossen sind.

5. Verwendung nach einem der Ansprüche 1 bis 4, **dadurch gekennzeichnet, dass** der Abstand der Berührungssensoren (2, 3) zur gegenüberliegenden Fläche der undurchsichtigen Oberfläche zwischen 1 mm und 30 mm beträgt.

6. Verwendung nach einem der Ansprüche 1 bis 5, **dadurch gekennzeichnet, dass** die undurchsichtige Oberfläche, hinter welcher das berührungssensitive Bedienelement (1) angebracht ist, kein Teil der mit dem berührungssensitiven Bedienelement (1) gesteuerten Vorrichtungen ist.

7. Verwendung nach einem der Ansprüche 1 bis 6, **dadurch gekennzeichnet, dass** die kapazitiven Berührungssensoren (2, 3) Näherungssensoren sind, welche die Annäherung von Gegenständen ab einer gewissen Distanz, im Wesentlichen unabhängig von der Dicke der Oberfläche, erkennen, wobei die Empfindlichkeit der Berührungserkennung der kapazitiven Berührungssensoren (2, 3) in Abhängigkeit der Dicke der permanent undurchsichtigen Oberflächen eingestellt wird, indem mittels einer Steuerungsvorschrift für das Bedienelement (1) ein Grenz- bzw. Schwellwert gesetzt wird, ab welchem Kapazitätsänderungen als Berührungen registriert werden.

8. Verwendung nach einem der Ansprüche 1 bis 7, **dadurch gekennzeichnet, dass** das Bedienelement (1) ausgehend von einem gesperrten Zustand durch Berührung eines oder mehrerer Berührungssensoren (2, 3) aktiviert wird, wobei dabei als Rückmeldung zum Status des Bedienelements (1) an den Benutzer die Ausgabe eines akustischen oder fühlbaren Signals durch das Bedienelement (1) erfolgt oder die Ausgabe eines optischen Signals durch das Bedienelement (1) erfolgt, wobei im Fall des optischen Signals das Bedienelement (1) ein oder mehrere Leuchtmittel (4) aufweist, wobei die Leuchtmittel (4) hinter Öffnungen (6) oder in Öffnungen (6) der undurchsichtigen Oberfläche vorliegen, wobei während dem aktivierten Stadium ein oder mehrere Leuchtmittel (4) den aktiven Modus anzeigen.

9. Verwendung nach einem der Ansprüche 1 bis 8, **dadurch gekennzeichnet, dass** die undurchsichtige Oberfläche an der dem Benutzer zugewandten Seite sichtbare und/oder fühlbare Markierungen aufweist, welche entsprechend den Berührungspunkten beziehungsweise Berührungsbereichen angeordnet sind.

10. Verwendung nach einem der Ansprüche 1 bis 9, **dadurch gekennzeichnet, dass** das Bedienelement (1) mehrere Berührungssensoren (2) aufweist, welche zur Steuerung der Smart Home Anwendung und/oder der Geräte von Gebäudeautomationssystemen dienen und zumindest einen weiteren Berührungssensor (3), wobei die mehrere Berührungssensoren (2) erst zur Steuerung verwendet werden können, wenn der dem weiteren Berührungssensor (3) gegenüberliegende Bereich der undurchsichtigen Oberfläche davor für eine definierte Zeitdauer berührt wurde.

11. Verwendung nach einem der Ansprüche 1 bis 10, **dadurch gekennzeichnet, dass** das Bedienelement (1) mit einer Datenverarbeitungsanlage kommuniziert, welche der Server oder die zentrale Recheneinheit eines Gebäudeautomationssystems oder eines Smart Homes ist, wobei die Datenverarbeitungsanlage die Steuerung von dezentralen Geräten von Gebäudeautomationssystemen aufgrund der Signale des Bedienelements (1) vornimmt.

12. Verwendung nach einem der Ansprüche 1 bis 12, **dadurch gekennzeichnet, dass** das Bedienelement (1) mit Berührungssensoren (2, 3) und Leuchtmitteln (4) versehen ist.

13. Verwendung nach Anspruch 12, **dadurch gekennzeichnet, dass** das Bedienelement (1) zumindest vier je in einem Eckbereichen eines Rechtecks angeordneten Berührungssensoren (2) aufweist, wobei vom Rechteck ein Fortsatz abragt, welcher die Leuchtmittel (4) und einen Berührungssensor (3) trägt.

14. Verwendung nach Anspruch 13, **dadurch gekennzeichnet, dass** der Berührungssensor (3) nahe am letzten, somit vom rechteckigen oder quadratischen Teil am weitesten entfernt liegenden Leuchtmittel (4) des Fortsatzes vorgesehen ist.

15. Verwendung nach einem der Ansprüche 12 bis 14, **dadurch gekennzeichnet, dass** das Bedienelement (1) ein Ausgabeelement für ein akustisches oder fühlbares Signal umfasst.

## Claims

1. Use of a touch-sensitive operating element (1) in a system for controlling a smart home application and/or devices of building automation systems comprising at least one touch-sensitive operating element (1), a central data processing system and decentralised devices of the building automation system which are controlled or directed by the data processing system, wherein the operating element (1) is disposed behind a permanently opaque surface on the bottom side of a plate of a building wall, a piece of furniture, a kitchen or a worktop and has capacitive touch sensors (2, 3) which detect users' touches of the permanently opaque surface through the plate, wherein each touch sensor (2, 3) senses touching of the opaque surface in an area, so that multiple touch points and/or touch areas are defined on the surface of the opaque surface opposite the touch sensors (2, 3), wherein the operating element (1) communicates with the central data processing system which controls or directs at least one decentralised device of the building automation system based on the detected touches and the respective deposited control protocols, wherein undesired and/or unconscious activation of the touch-sensitive operating element (1) is prevented
by the control of the smart home application and/or of devices of the building automation systems being deactivated by the touch-sensitive operating element (1) in a normal state, as well as the steps:
activating the operating element (1) from a locked state into an activated state by touching one or more of the touch points and/or touch areas (2, 3)
and one of more of the steps selected from the group of steps comprising:
issuing an acoustic or tactile signal by the operating element (1) to the user as a response to the active status of the operating element (1);
or
issuing an optical signal by the operating element (1) to the user as a response to the active status of the operating element (1), wherein the operating element (1) has one or more luminants (4), wherein the luminants (4) are present behind apertures (6) or in apertures (6) of the opaque surface.

2. The use of claim 1, **characterised in that** multiple touch sensors (2, 3) are present spaced apart on the operating element (1), wherein each touch sensor (2, 3) senses the touch of the opaque surface in a discrete area, so that multiple touch points and/or touch areas are defined on the surface of the opaque surface opposite the touch sensors (2, 3).

3. The use of any one of claims 1 and 2, **characterised in that** the operating element (1) has multiple touch sensors (2) for controlling the smart home application and/or the devices of building automation systems and at least one touch sensor (3) for unlocking the touch sensors (2) for controlling the smart home application and/or the devices of building automation systems.

4. The use of any one of claims 1 to 3, **characterised in that** the operating element (1) has one or more luminants, wherein the luminants (4) are present behind apertures (6) or in apertures (6) of the opaque surface, wherein the apertures (4) are sealed using transparent or at least translucent material.

5. The use of any one of claims 1 to 4, **characterised in that** the distance of the touch sensors (2, 3) from the opposite face of the opaque surface is between 1mm and 30mm.

6. The use of any one of claims 1 to 5, **characterised in that** the opaque surface, behind which the touch-sensitive operating element (1) is disposed, is not part of the apparatuses controlled using the touch-sensitive operating element (1).

7. The use of any one of claims 1 to 6, **characterised in that** the capacitive touch sensors (2, 3) are proximity sensors which recognise the approximation of objects at a certain distance essentially independent of the thickness of the surface, wherein the sensitivity of touch recognition of the capacitive touch sensors (2, 3) is adjusted depending on the thickness of the permanently opaque surfaces by setting a limit and/or threshold value by means of a control protocol for the operating element (1), from which changes in capacity will be registered as touches.

8. The use of any one of claims 1 to 7, **characterised in that** the operating element (1) is activated from a locked state into an activated state by touching one or more touch areas (2, 3), wherein in doing so, an acoustic or tactile signal is issued by the operating element (1) or an optical signal is issued by the operating element (1) as a response to the status of the operating element (1) to the user, wherein in the case of an optical signal the operating element (1) has one or more luminants (4), wherein the luminants (4) are present behind apertures (6) or in apertures (6) of the opaque surface, wherein one or more luminants (4) display the active mode during the activated state.

9. The use of any one of claims 1 to 8, **characterised in that** the opaque surface has visible and/or tactile marks, which are arranged according to the touch points and/or touch areas, on its side facing away from the user.

10. The use of any one of claims 1 to 9, **characterised in that** the operating element (1) has multiple touch sensors (2), which serve to control the smart home application and/or the devices of building automation systems, and at least one further touch sensor (3), wherein the multiple touch sensors (2) may only be used for controlling when the area of the opaque surface opposite the further touch sensor (3) has been previously touched for a predefined duration.

11. The use of any one of claims 1 to 10, **characterised in that** the operating element (1) communicates with a data processing system, which is the server or the central processing unit of a building automation system or a smart home, wherein the data processing system conducts control of decentralised devices of building automation systems based on the signals of the operating element (1).

12. The use of any one of claims 1 to 11, **characterised in that** the operating element (1) is provided with touch sensors (2, 3) and luminants (4).

13. The use of claim 12, **characterised in that** the operating element (1) has at least four touch sensors (2), each arranged in one of the corner areas of a rectangle, wherein an extension carrying the luminants (4) and a touch sensor (3) protrudes from the rectangle.

14. The use of claim 13, **characterised in that** the touch sensor (3) is provided close to the last luminant (4) of the extension, which is thus the one farthest away from the rectangular or square part.

15. The use of any one of claims 12 bis 14, **characterised in that** the operating element (1) comprises an issuing element for an acoustic or tactile signal.

## Revendications

1. Utilisation d'un élément de commande (1) tactile dans un système de commande d'une application de maison intelligente et/ou d'appareils de systèmes de domotique comprenant au moins un élément de commande (1) tactile, une installation centrale de traitement de données et des appareils décentralisés du système de domotique, qui sont contrôlés ou commandés par ladite installation de traitement de données, l'élément de commande (1) étant monté derrière une surface opaque en permanence sur la face inférieure d'un panneau d'un mur de bâtiment, d'un meuble, d'une cuisine ou d'un plan de travail et présentant des capteurs de contact capacitifs (2, 3) qui détectent des contacts d'utilisateurs avec la surface opaque en permanence, chaque capteur de contact (2, 3) détectant le contact avec la surface opaque dans une zone, de sorte que plusieurs points de contact ou zones de contact sont définis sur la face de la surface opaque qui est opposée aux capteurs de contact (2, 3), l'élément de commande (1) communiquant avec l'installation centrale de traitement des données, qui contrôle ou commande au moins un appareil décentralisé du système de domotique sur la base des contacts détectés et des prescriptions de commande enregistrées à cet effet, une activation involontaire et/ou inaperçue de l'élément de commande (1) tactile étant empêchée
en désactivant la commande de l'application de maison intelligente et/ou d'appareils de systèmes de domotique par l'élément de commande (1) tactile dans l'état normal et en prenant les mesures suivantes :
activation de l'élément de commande (1) à partir d'un état bloqué en touchant un ou plusieurs des points de contact ou des zones de contact des capteurs de contact (2, 3) pour le mettre dans un état activé
et une ou plusieurs des mesures choisies parmi le groupe de mesures comprenant :
émission d'un signal sonore ou tactile par l'élément de commande (1), en tant qu'information sur l'état actif de l'élément de commande (1) pour l'utilisateur ;
ou
émission d'un signal optique par l'élément de commande (1), en tant qu'information sur l'état actif de l'élément de commande (1) pour l'utilisateur, l'élément de commande (1) présentant un ou plusieurs moyens d'éclairage (4), les moyens d'éclairage (4) étant présents derrière des ouvertures (6) ou dans des ouvertures (6) de la surface opaque.

2. Utilisation selon la revendication 1, **caractérisée en ce que** plusieurs capteurs de contact (2, 3) sont présents sur l'élément de commande (1) à une certaine distance les uns des autres, chaque capteur de contact (2, 3) détectant des contacts avec la surface opaque dans une zone discrète de sorte que plusieurs points de contact discrets ou plusieurs zones de contact discrètes sont définis sur la face de la surface opaque qui est opposée aux capteurs de contact (2, 3).

3. Utilisation selon l'une des revendications 1 ou 2, **caractérisée en ce que** l'élément de commande (1) comporte plusieurs capteurs de contact (2) pour commander l'application de maison intelligente et/ou les appareils de systèmes de domotique et au moins un capteur de contact (3) pour déverrouiller les capteurs de contact (2) pour commander l'application de maison intelligente et/ou les appareils de systèmes de domotique.

4. Utilisation selon l'une des revendications 1 à 3, **caractérisée en ce que** l'élément de commande (1) présente un ou plusieurs moyens d'éclairage, les moyens d'éclairage (4) étant présents derrière des ouvertures (6) ou dans des ouvertures (6) de la surface opaque, les ouvertures (6) étant fermées par un matériau transparent ou au moins translucide.

5. Utilisation selon l'une des revendications 1 à 4, **caractérisée en ce que** la distance entre les capteurs de contact (2, 3) et la face opposée de la surface opaque est comprise entre 1 mm et 30 mm.

6. Utilisation selon l'une des revendications 1 à 5, **caractérisée en ce que** la surface opaque derrière laquelle l'élément de commande tactile (1) est monté ne fait pas partie des dispositifs commandés par l'élément de commande tactile (1).

7. Utilisation selon l'une des revendications 1 à 6, **caractérisée en ce que** les capteurs de contact capacitifs (2, 3) sont des capteurs de proximité qui détectent l'approche d'objets à partir d'une certaine distance, essentiellement indépendamment de l'épaisseur de la surface, la sensibilité de la détection de contact des capteurs de contact capacitifs (2, 3) étant réglée en fonction de l'épaisseur des surfaces opaques en permanence, en fixant une valeur limite ou une valeur de seuil à l'aide d'une instruction de commande pour l'élément de commande (1), à partir de ladite valeur les variations de capacité étant enregistrées comme des contacts.

8. Utilisation selon l'une des revendications 1 à 7, **caractérisée en ce que** l'élément de commande (1) est activé à partir d'un état bloqué quand un ou plusieurs capteurs de contact (2, 3) sont touchés, un signal sonore ou un signal tactile étant émis par l'élément de commande (1) ou un signal optique étant émis par l'élément de commande (1) en tant qu'information pour l'utilisateur pour lui signaller l'état de l'élément de commande (1), l'élément de commande (1) présentant un ou plusieurs moyens d'éclairage (4) au cas d'un signal optique, les moyens d'éclairage (4) se trouvant derrière des ouvertures (6) ou dans des ouvertures (6) de la surface opaque, un ou plusieurs moyens d'éclairage (4) indiquant le mode actif dans l'état activé.

9. Utilisation selon l'une quelconque des revendications 1 à 8, **caractérisée en ce que** la surface opaque présente, sur la face tournée vers l'utilisateur, des marques visibles et/ou tactiles qui sont disposées en fonction des points de contact ou des zones de contact.

10. Utilisation selon l'une des revendications 1 à 9, **caractérisée en ce que** l'élément de commande (1) présente plusieurs capteurs de contact (2) qui servent à commander l'application de maison intelligente et/ou les appareils de systèmes de domotique et au moins un autre capteur de contact (3), lesdits plusieurs capteurs de contact (2) pouvant être utilisés pour commander seulement après que la zone de la surface opaque opposée à l'autre capteur de contact (3) a été touchée pendant une durée définie.

11. Utilisation selon l'une des revendications 1 à 10, **caractérisée en ce que** l'élément de commande (1) communique avec une installation de traitement de données qui est le serveur ou l'unité centrale de calcul d'un système de domotique ou d'une maison intelligente, l'installation de traitement de données commandant des appareils décentralisés de systèmes de domotique sur la base des signaux de l'élément de commande (1).

12. Utilisation selon l'une des revendications 1 à 11, **caractérisée en ce que** l'élément de commande (1) est pourvu de capteurs de contact (2, 3) et de moyens d'éclairage (4).

13. Utilisation selon la revendication 12, **caractérisée en ce que** l'élément de commande (1) présente au moins quatre capteurs de contact (2) disposés chacun dans une zone de coin d'un rectangle, un prolongement, qui porte les moyens d'éclairage (4) et un capteur de contact (3), faisant saillie du rectangle.

14. Utilisation selon la revendication 13, **caractérisée en ce que** le capteur de contact (3) est prévu à proximité du dernier moyen d'éclairage (4) du prolongement qui est donc le plus éloigné de la partie rectangulaire ou carrée.

15. Utilisation selon l'une des revendications 12 à 14, **caractérisée en ce que** l'élément de commande (1) comprend un élément de sortie pour un signal sonore ou tactile.
